# EUROPEAN PATENT APPLICATION

(11) **EP 4 607 591 A1**
(43) Date of publication of application: **27.08.2025**
(21) Application number: 24158776.5
(22) Date of filing: 21.02.2024
(51) Int. Cl.: H01L 23/538, H01L 23/64, H01L 23/66

(54) **A SEMICONDUCTOR COMPONENT INCLUDING ONE OR MORE CONDUCTORS COMPRISING A STACK OF FERROMAGNETIC AND NONMAGNETIC MATERIALS**

(71) Applicant: Imec VZW, 3001 Leuven (BE)
(72) Inventor: Sun, Xiao, 3012 Wilsele (BE); Huynen, Martijn, 9040 Sint-Amandsberg (BE); Beyne, Eric, 3001 Heverlee (BE)
(74) Representative: Patent Department IMEC

(57) **Abstract**

In a component according to the invention, for example an integrated circuit chip or an interposer chip (2), a dielectric layer (5) is provided having a planar upper surface (9) and a first trench (10) formed through the upper surface, the trench having a base (11) and upstanding sidewalls (12). A conductor (4) is arranged in the trench, the conductor comprising a stack (14) formed of alternately stacked non-magnetic layers and ferromagnetic layers (15,16). The stack conformally follows the base and sidewalls of the trench. In other words, the stack extends along said base and sidewalls, so that the stack itself defines an inner trench (17), i.e. a second trench inside the first trench. The second trench is filled with a central portion (18) of electrically conductive material. The presence of the stack (14) of ferromagnetic and non-magnetic layers suppresses the skin effect at high frequencies. The presence of the stack on the sidewalls of the first trench does not deteriorate the suppression of the skin effect in a largely applicable frequency range.

## Description

### Field of the Invention

The present invention is related to semiconductor processing, in particular to the production of interconnect lines suitable for high frequency signal transfer.

### State of the art.

New standards are being developed for signal transfer in semiconductor chips and in particular between chips in 2.5D and 3D architectures. For example, the UCIe specification (Universal Chiplet Interconnect express) addresses interconnects between small chips, also referred to as chiplets. Instead of making one big chip with all functionalities on it, UCIe interconnects different chiplets into broader packages. To minimize the explosion in the number of interconnect lines between chiplets, interconnects need to move to higher frequencies such as 38 Gigabit per second per interconnect line.

Traditional conductors such as copper wires however suffer from increased resistive loss at these high frequencies as a consequence of the skin effect: current travels through a thin outer layer of the conductor and not through the bulk, which increases the resistance significantly.

As a solution to the skin effect, it is known to produce multilayered conductors formed of alternating layers of ferromagnetic material and non-magnetic material. These so-called metaconductors have been studied in lab conditions where stacks of the alternating layers were produced by the lift-off process. Patent publication document US11605592 is related to methods for producing such metaconductors by damascene-type processing methods, wherein consecutive ferromagnetic and non-magnetic layers are deposited in a trench. In order to mimic the layer structure obtained by the lift-off process, the material formed on the sidewalls of the trench is removed, resulting in a metaconductor formed of parallel planar layers stacked in the trench. The removal of the sidewall-deposited material however complicates the process significantly.

### Summary of the invention

The invention is related to a semiconductor component, a semiconductor package, and to a method as disclosed in the appended claims. In a component according to the invention, for example an integrated circuit chip or an interposer chip, a dielectric layer is provided having a planar upper surface and a first trench formed through the upper surface, the trench having a base and upstanding sidewalls. The base can also be referred to as the floor of the trench. A conductor is arranged in the trench and thereby embedded in the dielectric layer, the conductor comprising a stack formed of alternately stacked ferromagnetic and non-magnetic layers. The stack conformally follows the base and sidewalls of the trench. In other words, the stack extends along said base and sidewalls, so that the stack itself defines an inner trench, i.e. a second trench inside the first trench, the second trench having a base and sidewalls which are essentially parallel to the base and sidewalls of the first trench. The second trench is filled with a central portion of electrically conductive material. The conductor thus consists of the stack of ferromagnetic and non-magnetic layers and of the central portion of conductive material. The upper surface of the conductor is coplanar with the upper surface of the dielectric layer.

The presence of the stack of ferromagnetic and non-magnetic layers suppresses the skin effect at high frequencies. The presence of the stack on the sidewalls of the first trench does not deteriorate the suppression of the skin effect in a largely applicable frequency range. The removal of the stack layers from said sidewalls is therefore not required during the production process of a component according to the invention. The conductors can be produced by a damascene-type process that is compatible with current industrial processing environments.

Preferred embodiments include conductors wherein the stack of ferromagnetic and non-magnetic layers is thin compared to the dimensions of the conductor as a whole. It was found that significant suppression of the skin effect can be achieved by providing the stack only in a thin outer region of the conductor, for example by providing a stack having a thickness that is less than 30%, less than 20% or less than 10% of the width of the conductor as measured in a plane defined by the upper surface of the dielectric layer into which the conductor is embedded. Depending on the dimensions of the conductor and the thickness of the individual layers of the stack, this can be achieved by a relatively low number of layers of said stack, for example not more than 10 layers.

The invention is in particular related to a semiconductor component comprising a semiconductor substrate and at least one layer of dielectric material, said layer having a planar upper surface, wherein an electrical conductor is arranged in a first trench formed in said layer of dielectric material, the first trench having a base and a pair of upstanding sidewalls, characterized in that the conductor comprises :
- a stack of alternate ferromagnetic and non-magnetic layers, said stack extending along the base and the sidewalls of the first trench so that the stack defines a second trench inside the first trench. The second trench therefore has a base and sidewalls which are essentially parallel respectively to the base and the sidewalls of the first trench,
- an electrically conductive portion that integrally fills said second trench.

According to an embodiment, the electrically conductive portion that integrally fills the second trench is formed of a non-magnetic material.

According to an embodiment, the ferromagnetic layers of the stack are formed of the same ferromagnetic material, the non-magnetic layers of the stack are formed of the same non-magnetic material, and the electrically conductive portion that integrally fills the second trench is formed of the same material as the non-magnetic material of said non-magnetic layers of the stack.

According to an embodiment, the thickness of the stack is less than 30% of the width of the conductor, as measured in a plane defined by the upper surface of the layer f dielectric material. According to further embodiments, the thickness of the stack is less than 20% or less than 10% of said width.

According to an embodiment, the number of layers of the stack is not higher than 10.

According to an embodiment, the width of the conductor as measured in a plane defined by the upper surface of the layer of dielectric material is at least one micrometre, and the thickness of the layers of the stack is between 5 nm and 100 nm.

According to an embodiment, the stack is in direct contact with a diffusion barrier layer that lines the base and the sidewalls of the first trench.

According to an embodiment, said component is an interposer chip for mounting thereon a plurality of chiplets, and comprising at least one array of said conductors arranged parallel to each other and configured to interconnect two chiplets.

According to an embodiment, said component is a semiconductor chip comprising a back end of line portion including multiple levels of interconnected conductors, wherein at least one of said conductors of the back end of line portion is a conductor in accordance with the invention.

The invention is also related to a semiconductor package comprising an interposer chip according to the invention and a plurality of chiplets mounted on the interposer chip, and wherein the interposer chip comprises at least one array of said parallel conductors configured to interconnect two chiplets.

The invention is also related to a method for producing an electrical conductor comprising a stack of alternate ferromagnetic and non-magnetic layers, the method comprising the steps of :
- providing a substrate comprising a layer of dielectric material having a planar upper surface,
- producing a trench in the layer of dielectric material, the trench having a base and a pair of upstanding sidewalls,
- producing a stack of said alternate ferromagnetic and non-magnetic layers along the base and the sidewalls of the trench and on the upper surface of the layer of dielectric material, so that the stack defines a second trench inside the first trench,
- producing a layer of electrically conductive material directly on the top layer of the stack, said layer filling the second trench,
- planarizing the stack and the layer of conductive material, thereby removing the stack from the upper surface of the layer of dielectric material.

According to an embodiment of the method of the invention, the thickness of the stack is less than 30% of the width of the conductor, as measured in a plane defined by the upper surface of the layer of dielectric material. According to further embodiments of the method, the thickness of the stack is less than 20% or less than 10% of said width

According to an embodiment of the method of the invention, the number of layers of the stack is not higher than 10.

According to an embodiment of the method of the invention, the layer of electrically conductive material filling the second trench is a non-magnetic material.

### Brief description of the figures

Figure 1 is a simplified top view of an integrated semiconductor package comprising two chiplets interconnected in accordance with an embodiment of the invention.
Figure 2 is a cross-section view of a number of the conductors shown in Figure 1.
Figure 3 is a more detailed cross-section view of one of the conductors shown in Figure 2.
Figure 4 details the layers of the multilayer stack applied in the conductors.
Figures 5 and 6 show the structure of conductors not in accordance with the invention and used in a comparative simulation study.
Figure 7 illustrates the resistance as a function of AC frequency, for the conductors included in the comparative simulation.
Figures 9 to 11 illustrate consecutive steps applied in a method according to the invention.
Figure 12 illustrates a further example of a conductor in accordance with the invention.

### Detailed description of the invention

A conductor according to the invention is applicable in a variety of contexts in terms of the type of semiconductor component and/or package into which the conductor is incorporated. By way of example only, one particular context will first be described in some detail, namely the fabrication of interconnects between chiplets on an interposer chip. The invention is however not limited thereto and other applications will be mentioned later. Also, all materials and dimensions cited in the following detailed example are not limiting the scope of the invention. Alternatives to said materials and dimensions will also be described later in this text.

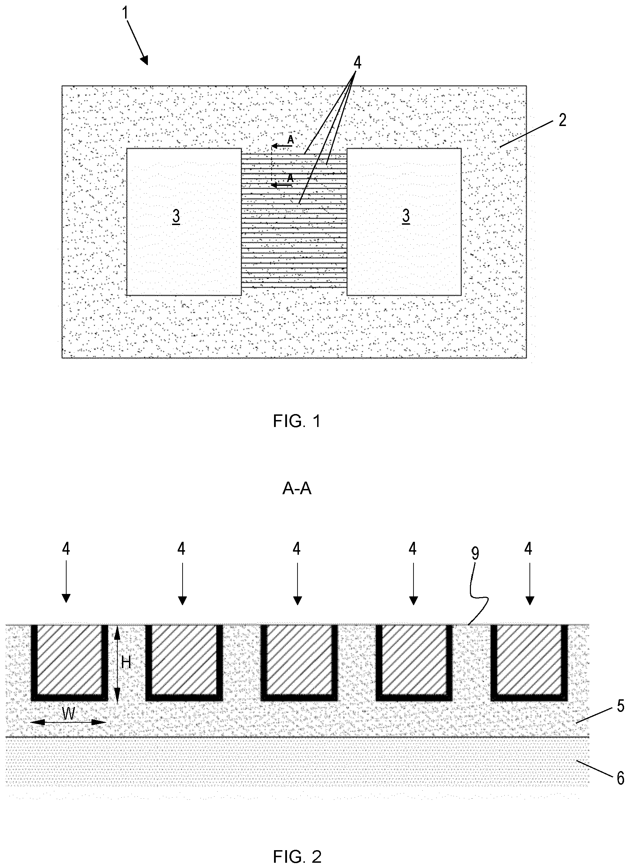

Figure 1 is a simplified top view of an integrated semiconductor package 1 including an interposer chip 2 and two chiplets 3 mounted on the interposer chip. Electrical connections between the chiplets 3 and the interposer chip 2 may be realized according to known technologies. An array of electrical conductors 4 interconnects the chiplets 3 directly. These conductors are realized in accordance with an embodiment of the invention.

Figure 2 shows a cross-section of a number of the conductors 4. They are embedded in a layer 5 of dielectric material (hereafter also referred to as 'dielectric layer') that lies on the upper surface of a semiconductor substrate portion 6 of the interposer chip 2. The dielectric layer 5 may be part of a redistribution layer of the interposer chip 2 for example. Such redistribution layers are well-known and details thereof are therefore not included here. The dielectric layer 5 may be a layer of silicon oxide (SiO₂) for example.

The width W and height H of the conductors 4 as seen in the cross section is about 5 µm and the pitch of the array of conductors 4 is about 7.5 µm. The upper surface of the conductors 4 is at the same level as the planar upper surface 9 of the dielectric layer 5. In a finalized package, these upper surfaces are covered by a further dielectric layer serving as passivation layer or sealing layer of the package. These layers are also well known in the art and not represented in Figures 1 and 2.

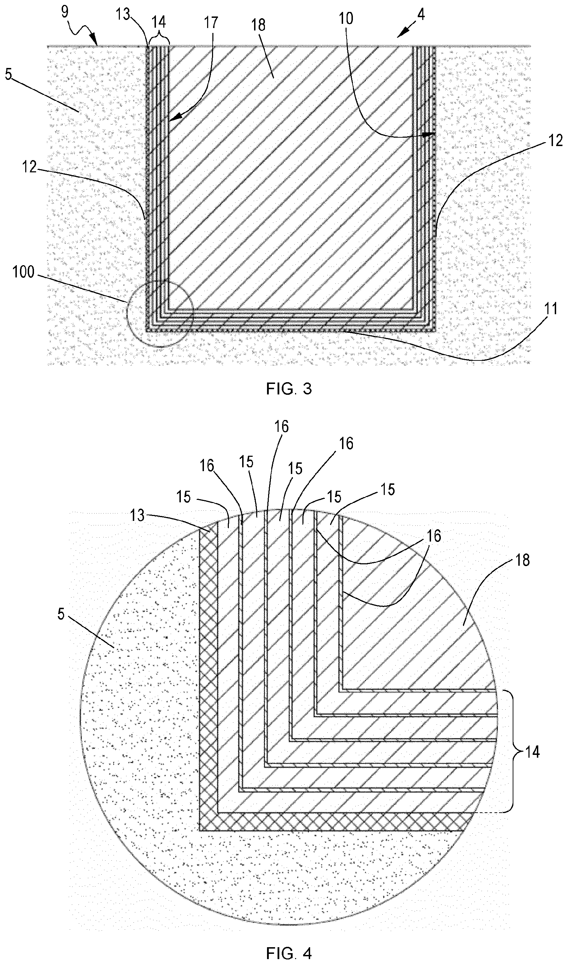

An enlarged view of the cross section of one conductor 4 is shown in Figure 3, and a detail of a corner portion 100 of said cross section is represented in Figure 4. It is seen that the conductor 4 is arranged in a trench 10 in the dielectric layer 5. The trench 10 comprises a level base 11 and upstanding sidewalls 12. The sidewalls 12 are shown to be perpendicular with respect to the base 11 but they can alternatively be slightly slanted outwardly and mutually symmetrically with respect to the base 11.

In direct physical contact with the base 11 and the sidewalls 12 of said trench 10 is a diffusion barrier layer 13 of about 50 nm in thickness. This diffusion barrier layer 13 is required in most cases but could be omitted depending on the precise application and the choices made in terms of materials and dimensions. The diffusion barrier 13 is therefore optional within the broader scope of the present invention.

Lying directly on the diffusion barrier layer 13 is a stack 14 of alternately applied non-magnetic and ferromagnetic layers, referred to hereafter as a 'multistack' or simply 'stack' 14. In the exemplary embodiment, the multistack 14 is formed of Cu layers (non-magnetic) 15 of about 60 nm in thickness, and of Co layers (ferromagnetic) 16 of about 10 nm thick. The total number of Cu and Co layers is 10 (5 Cu layers and 5 Co layers).

The multistack 14 extends along the base 11 and the sidewalls 12 of the trench 10 so that the stack 14 defines a second trench 17 inside the first trench 10, the second trench 17 having a base and sidewalls which are essentially parallel respectively to the base 11 and the sidewalls 12 of the first trench 10.

The remainder of the conductor 4 is formed by a bulk Cu portion 18 that integrally fills the second trench 17. The diffusion barrier layer 13 is not regarded within the present context as part of the conductor 4 in accordance with the invention, i.e. said conductor 4 consists of the multistack 14 of Cu and Co layers and of the bulk Cu portion 18. The width W and the height H of the conductor 4, as indicated in Figure 2 therefore do not include the thickness of the diffusion barrier layer 13. The thickness of the multistack 14 in this particular example is 5 × 60 + 5 × 10 = 350 nm, which is about 7% of the width W (5 µm) of the conductor 4.

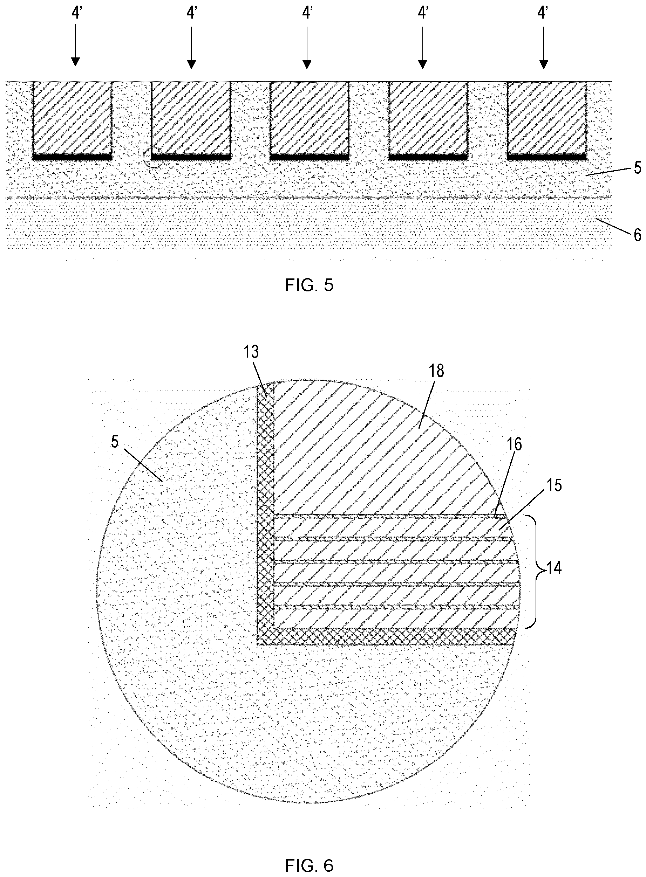

The multistack 14 of Cu and Co layers 15 and 16 is effective in suppressing the skin effect when the conductors 4 are used for conducting high frequency AC currents. The fact that the multistack 14 is formed not only on the base 11 but also on the sidewalls 12 of the trench 10 is not detrimental in terms of the skin effect suppression. This is demonstrated by a comparative simulation that compares the conductors 4 shown in Figures 2 to 4 with conductors 4' illustrated in Figures 5 and 6, which are not in accordance with the invention. In the latter case, the multistack 14 of Cu and Co layers 15/16 having the same thicknesses as above (60 nm and 10 nm) is formed only on the base 11 of the trench 10, on top of the diffusion barrier 13, and the bulk Cu portion 18 fills the remainder of the trench 10. The diffusion barrier 13 is formed also on the sidewalls of the trench 10 in order to stop diffusion from the bulk Cu portion 15 into the dielectric layer 5.

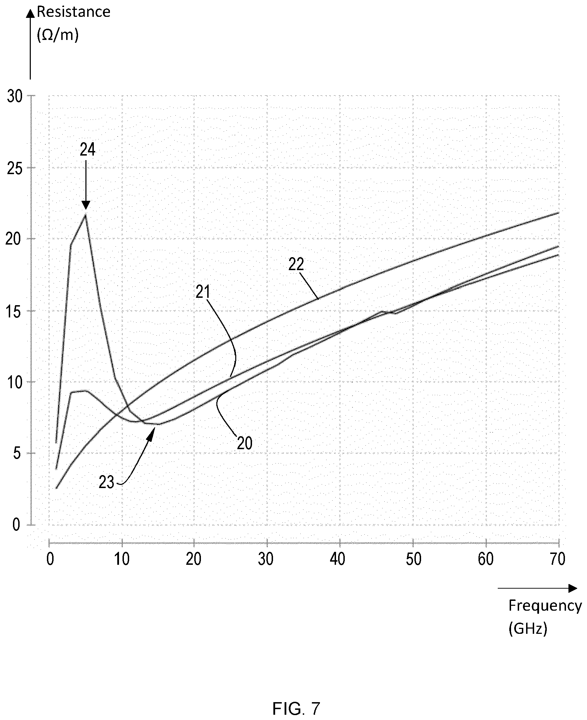

Figure 7 compares the resistance of the conductors 4 according to the invention (Figures 2-4) to the resistance of conductors 4' as shown in Figures 5 and 6, and to conductors (not shown) formed fully of Cu. Results are obtained from a simulation of the respective conductors having dimensions and materials as described above. The full Cu conductor is a conductor fully formed of Cu and having a cross section of about 5 µm × 5 µm. The curves express the resistance as a function of the frequency of the conducted current. Curve 20 represents the conductors 4 according to the invention, curve 21 represents the conductors 4' having only a multistack on the base of the cavity 10 and curve 22 represents the full Cu conductor (no multistack). It is seen that within a wide frequency range above 10 GHz, conductors 4 and 4' have essentially the same effectiveness in terms of suppressing the skin effect. At lower frequencies, to the left of the minimum 23, the conductor 4 according to the invention, i.e. with the multistack 14 formed on the sidewalls 12 of the trench 10, exhibits an undesirable peak 24 in the resistance. However, these frequencies are outside the applicable range for most signal transfer applications. It is concluded that conductors in accordance with the invention are effective for suppressing the skin effect at high frequencies applicable in a number of signal transfer applications, such as the signal transfer between chiplets illustrated in Figure 1.

Preferably but not exclusively, and as is the case in the described example, all the ferromagnetic layers 16 of the multistack 14 are formed of the same ferromagnetic material and all the non-magnetic layers 15 of the stack are formed of the same non-magnetic material. Also preferably but not exclusively, all the ferromagnetic layers 16 of the stack have the same thickness and all the non-magnetic layers 15 have the same thickness.

Within these latter conditions (same materials and thicknesses of the ferromagnetic and respectively the non-magnetic layers of the stack), the total number of layers in the multistack 14 and the ratio between the thicknesses of the non-magnetic layers 15 and the ferromagnetic layers 16 are parameters which are able to influence the relation between the resistance and the frequency, as represented by the curve 20 in the exemplary case described above. For example, a higher ratio of the thickness of the non-magnetic layers 15 to the thickness of the ferromagnetic layers 16 is able to move the minimum 23 to lower frequency values. Also, for a given thickness of the non-magnetic and ferromagnetic layers of the stack, increasing the total number of layers decreases the resistance level in the applicable range (i.e. the frequency range above the minimum 23). However, this increase becomes smaller and smaller as the number of layers becomes higher. From simulations based on the above-described configuration (conductor width and height about 5 µm, Cu layers of 60 nm and Co layers of 10 nm, total of 10 layers in the multistack), it was apparent that a further increase of the number of layers above 10 does not significantly improve (i.e. additionally lower) the resistance in the frequency range of interest (above 10 GHz).

Preferred embodiments of the invention are defined by the fact that the thickness of the multistack 14 is low compared to the total width W of the conductor as measured in a plane defined by the upper surface 9 of the dielectric layer 5 (the latter definition of W is applicable regardless of whether the sidewalls 12 of the trench 10 are perpendicular to the base 11 or slanted outwardly). According to various embodiments, the thickness of the multistack 14 is less than 30%, less than 20% or less than 10% of said width W as defined above.

In practice, embodiments wherein the thickness of the multistack 14 is thin compared to the width of the conductor are primarily applicable to conductors having a width and height in the order of several micrometres, and wherein the thickness of the layers of the multistack is in the order of nanometres, for example between 5 and 100 nm, as in the above-described example. These embodiments are advantageous compared to prior art configurations because the removal of the multistack layers from the sidewalls 12 of the trench 10 is not required, and only a limited number of multistack layers, for example not more than 10 or not more than 20, is needed to obtain the desired effect of suppressing the skin effect and thereby reducing the resistance at high frequencies.

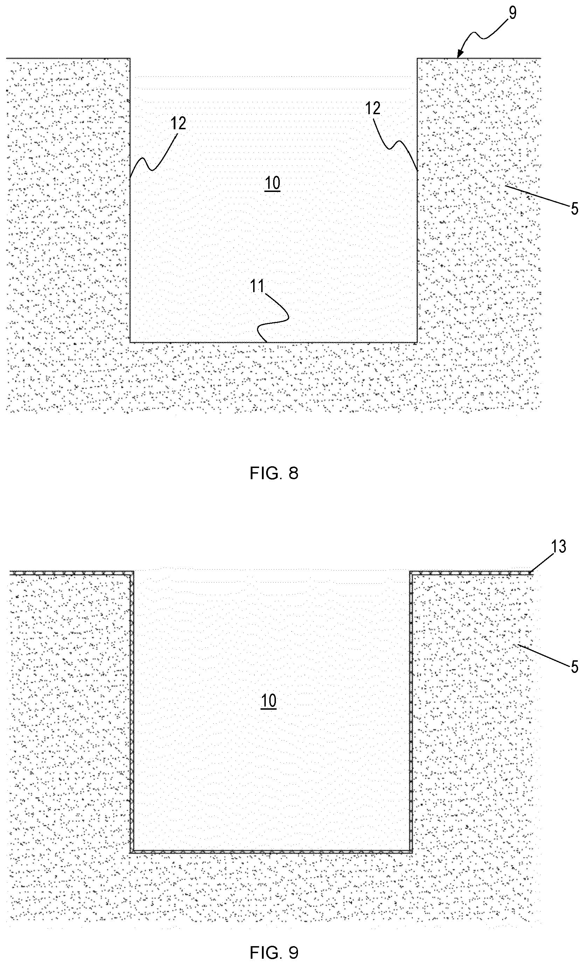

A method according to the invention for producing conductors 4 as described with reference to Figures 2 to 4 is illustrated in Figures 8 to 11. With reference to Figure 8, a trench 10 is formed in the dielectric layer 5. The trench 10 has a depth and width in the order of 5 µm. The length of the trench is determined by the required layout of which the conductor 4 will be a part. The trench 10 is formed by well-known lithography and etching techniques. The trench has a level base 11 and upstanding sidewalls 12.

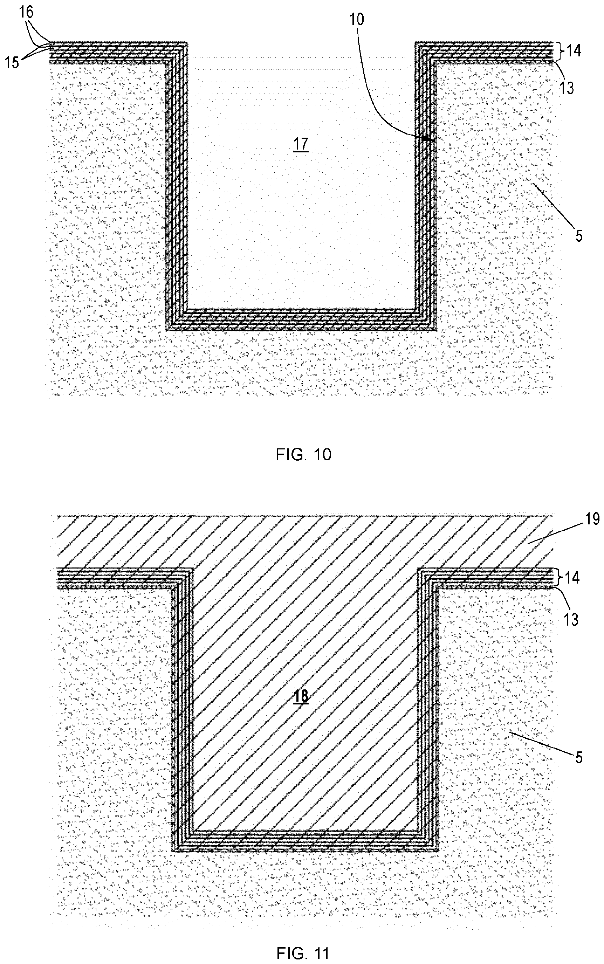

With reference to Figure 9, the diffusion barrier layer 13 is deposited conformally on the dielectric layer 5, i.e. following the topography defined by the trench 10 and the upper surface 9 of the layer 5. Then the Cu and Co layers 15 and 16 are deposited sequentially and alternately, also conformally following said topography, as illustrated in Figure 10, so that the multistack 14 is formed, extending along the base 11 and on the sidewalls 12 of the trench 10 and on the upper surface of the dielectric layer 5, and thereby defining the second trench 17 inside the first trench 10 as described above.

Both the diffusion barrier 13 and the Cu and Co layers 15 and 16 may be formed by known techniques, such as PVD (physical vapour deposition) or ALD (atomic layer deposition). Cu is then deposited non-conformally, as illustrated in Figure 11, i.e. the Cu fills the second trench 17, forming the bulk Cu portion 18 of the eventual conductor and a layer 19 of Cu on top of the horizontal parts of the multistack layer 14. The Cu 18,19 may be formed by first depositing a Cu seed layer conformally in the trench 17 and on the upper surface of the dielectric layer 5, followed by electrodeposition of Cu in the trench and on said upper surface.

Planarization is then applied, which may include grinding and CMP (chemical mechanical polishing), for removing the Cu layer 19 and the stack 14 from the upper surface of the dielectric layer 5. Possibly also a small upper portion of said dielectric layer 5 is removed, resulting in the embedded conductor 4 shown in Figure 3, having an upper surface that is coplanar with the upper surface 9 of the dielectric layer 5.

These method steps thus correspond to a damascene-type processing for producing metaconductors aimed at reducing the skin effect at high frequencies, but wherein the multistack layers formed on the sidewalls 12 of the trench 10 are not removed. The method is therefore less technically complex compared to methods wherein the sidewall-deposited portions of the multistack layers are removed. The preferred embodiments wherein the thickness of the multistack 14 is small compared to the width W of the conductor are furthermore particularly advantageous, as it is clear that the sidewall-deposited portions do not have a detrimental effect on the resistance within a widely applicable frequency range, and that a limited number of layers suffices to obtain the desired skin effect suppression within said frequency range.

As stated above, the invention is applicable in a wide variety of technical configurations, not limited to the chiplet assembly shown in Figure 1. Arrays of conductors 4 having similar dimensions can be applied in any assembly comprising any number of chips or chiplets mounted on an interposer. The conductors could be produced in a so-called silicon bridge mounted on an interposer chip and aimed specifically at forming an electrically conductive bridge between adjacent chips or chiplets also mounted on the interposer. Also, conductors according to the invention can be applied internally in an integrated circuit chip, namely in the back end of line portion (BEOL) of the chip, preferably in the upper layers of the BEOL portion where conductors have larger dimensions compared to the lower layers.

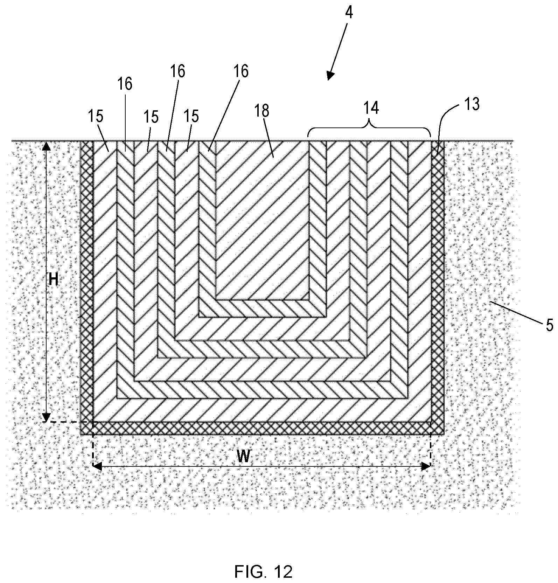

The invention is not limited to conductors 4 having the multistack 14 confined to a thin outer layer as shown above. Figure 12 shows a conductor 4 according to the invention, wherein the thickness of the multistack 14 is much higher compared to the width W of the conductor 4 as a whole. The width W and height H of the conductor 4 may for example be in the order of half a micrometre in this case, with the thickness of the barrier layer 13 and of the non-magnetic layers 15 (for example Cu) and the ferromagnetic layers 16 (for example Co) in the same order of magnitude as in the previously described embodiment, for example between 10 nm and 100 nm.

Applicable materials for the ferromagnetic and non-magnetic layers of the multistack 14 in a conductor according to the invention include any non-magnetic metals with sufficient conductivity for practical signal processing applications, such as Cu, W, Al, etc. For the ferromagnetic layers, known ferromagnetic metals are applicable, including Co, Fe, Ni, and alloys of these materials.

In the examples described above, the first layer of the multistack 14, i.e. the layer formed directly on the base 11 and sidewalls 12 of the trench 10 or on the diffusion barrier layer 13, is a non-magnetic layer 15 (Cu in the described examples). Alternatively, the first layer could be a ferromagnetic layer. The total number of layers in the multistack 14 may be an even number, in which case there are as many ferromagnetic layers as non-magnetic layers, or an uneven number, in which case the top layer of the stack is the same (ferromagnetic or non-magnetic) as the bottom layer. As in the presented example, the central conductive portion 18 may be non-magnetic and preferably formed of the same material as the non-magnetic layers of the multistack 14. It is also possible however that the central conductive portion 18 is formed of a ferromagnetic material, preferably the same ferromagnetic material as the ferromagnetic layers of the stack 14.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

Unless specifically specified, the description of a layer being present, deposited or produced 'on' another layer or substrate, includes the options of
- said layer being present, produced or deposited directly on, i.e. in physical contact with, said other layer or substrate, and
- said layer being present, produced or deposited on one or a stack of intermediate layers between said layer and said other layer or substrate.

## Claims

1. A semiconductor component comprising a semiconductor substrate (6) and at least one layer (5) of dielectric material, said layer having a planar upper surface (9), wherein an electrical conductor (4) is arranged in a first trench (10) formed in said layer (5) of dielectric material, the first trench having a base (11) and a pair of upstanding sidewalls (12), **characterized in that** the conductor comprises :
- a stack (14) of alternate ferromagnetic and non-magnetic layers (15,16), said stack extending along the base and the sidewalls of the first trench (10) so that the stack defines a second trench (17) inside the first trench,
- an electrically conductive portion (18) that integrally fills said second trench (17).

2. A semiconductor component according to claim 1, wherein the electrically conductive portion (18) that integrally fills the second trench (17) is formed of a non-magnetic material.

3. A semiconductor component according to claim 1 or 2, wherein the ferromagnetic layers (16) of the stack (14) are formed of the same ferromagnetic material and wherein the non-magnetic layers (15) of the stack are formed of the same non-magnetic material, and wherein the electrically conductive portion (18) that integrally fills the second trench (17) is formed of the same material as the non-magnetic material of said non-magnetic layers (15) of the stack (14).

4. A semiconductor component according to any one of the preceding claims, wherein the thickness of the stack (14) is less than 30% of the width of the conductor, as measured in a plane defined by the upper surface (9) of the layer (5) of dielectric material.

5. A semiconductor component according to any one of the preceding claims, wherein the number of layers of the stack (14) is not higher than 10.

6. A semiconductor component according to any one of the preceding claims, wherein the width (W) of the conductor as measured in a plane defined by the upper surface (9) of the layer (5) of dielectric material is at least one micrometre, and wherein the thickness of the layers (15,16) of the stack is between 5 nm and 100 nm.

7. A semiconductor component according to any one of the preceding claims, wherein the stack (14) is in direct contact with a diffusion barrier layer (13) that lines the base (11) and the sidewalls (12) of the first trench (10).

8. A semiconductor component according to any one of the preceding claims, wherein said component is an interposer chip (2) for mounting thereon a plurality of chiplets (3), and comprising at least one array of said conductors (4) arranged parallel to each other and configured to interconnect two chiplets (3).

9. A semiconductor component according to any one of claims 1 to 7, wherein said component is a semiconductor chip comprising a back end of line portion including multiple levels of interconnected conductors, and wherein at least one of said conductors of the back end of line portion is a conductor (4) as described in any one of claims 1 to 7.

10. A semiconductor package (1) comprising an interposer chip (2) according to claim 8 and a plurality of chiplets (3) mounted on the interposer chip (2), and wherein the interposer chip (2) comprises at least one array of said parallel conductors (4) configured to interconnect two chiplets (3).

11. A method for producing an electrical conductor (4) comprising a stack (14) of alternate ferromagnetic and non-magnetic layers (15,16), the method comprising the steps of :
- providing a substrate comprising a layer (5) of dielectric material having a planar upper surface (9),
- producing a trench (10) in the layer of dielectric material, the trench having a base (11) and a pair of upstanding sidewalls (12),
- producing a stack (14) of said alternate ferromagnetic and non-magnetic layers (15,16) along the base (11) and the sidewalls (12) of the trench (10) and on the upper surface of the layer (5) of dielectric material, so that the stack defines a second trench (17) inside the first trench (10),
- producing a layer (18,19) of electrically conductive material directly on the top layer of the stack (14), said layer filling the second trench (17),
- planarizing the stack (14) and the layer (18,19) of conductive material, thereby removing the stack from the upper surface of the layer (5) of dielectric material.

12. The method according to claim 11 wherein the thickness of the stack (14) is less than 30% of the width of the conductor (4), as measured in a plane defined by the upper surface (9) of the layer (5) of dielectric material.

13. The method according to claim 11 or 12, wherein the number of layers of the stack (14) is not higher than 10.

14. The method according to any one of claims 11 to 13, wherein the layer (18,19) of electrically conductive material filling the second trench (17) is a non-magnetic material.
